(19) Europäisches Patentamt
European Patent Office
Office européen des brevets

(11) **EP 4 287 250 A1**

(12) **EUROPEAN PATENT APPLICATION**
published in accordance with Art. 153(4) EPC

(43) Date of publication:
**06.12.2023 Bulletin 2023/49**

(21) Application number: **22745982.3**

(22) Date of filing: **27.01.2022**

(51) International Patent Classification (IPC):
**H01L 23/29** (2006.01)    **H01L 23/31** (2006.01)
**H01L 21/56** (2006.01)

(52) Cooperative Patent Classification (CPC):
**H01L 21/56; H01L 23/29; H01L 23/31**

(86) International application number:
**PCT/JP2022/003123**

(87) International publication number:
**WO 2022/163763 (04.08.2022 Gazette 2022/31)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **01.02.2021  JP 2021014655**

(71) Applicant: **NAGASE CHEMTEX CORPORATION**
**Osaka-shi, Osaka 550-8668 (JP)**

(72) Inventors:
• **OI Yosuke**
  **Tatsuno-shi, Hyogo 679-4124 (JP)**
• **ASAHARA Masahiro**
  **Tatsuno-shi, Hyogo 679-4124 (JP)**
• **MORI Daisuke**
  **Tatsuno-shi, Hyogo 679-4124 (JP)**

(74) Representative: **Keltie LLP**
**No. 1 London Bridge**
**London SE1 9BA (GB)**

(54) **METHOD FOR SEALING ELECTRONIC COMPONENT MOUNTING SUBSTRATE, AND HEAT-CURABLE SHEET**

(57) A method for sealing an electronic component mounting substrate including: preparing an electronic component mounting substrate including a substrate and electronic components mounted thereon and having a space between an electronic component and the substrate; placing a thermosetting sheet on the electronic component mounting substrate; and heat-molding the placed thermosetting sheet, to allow a melt of the thermosetting sheet to fill the space between the electronic component and the substrate and be cured. When a distance between the center of the substrate and an optional point P on a frame line that surrounds all the electronic components and minimizes the surrounded area is denoted by Lp, a distance Lq between the center of the substrate and a point Q at which a straight line passing through the point P and the center of the substrate intersects with an outer periphery of the thermosetting sheet is 0.9Lp or more.

FIG. 2

**Description**

[Technical Field]

The present invention relates to a method for sealing an electronic component mounting substrate, and a thermosetting sheet.

[Background Art]

In a typical method for sealing electronic components connected by a flip-chip connection method, after underfilling with a liquid sealing material having fluidity is performed with respect to the spaces between the electronic components and the substrate, overmolding with another liquid sealing material or a sealing film is performed (see Patent Literatures 1 to 3).
On the other hand, in order to reduce the number of process steps, one proposal suggests a mold underfill material that enables to perform underfilling and overmolding simultaneously (Patent Literature 4).

[Citation List]

[Patent Literature]

Patent Literature 1: Japanese Laid-Open Patent Publication No. 2014-131016
Patent Literature 2: Japanese Laid-Open Patent Publication No. 2014-229769
Patent Literature 3: Japanese Laid-Open Patent Publication No. 2015-178635
Patent Literature 4: Japanese Laid-Open Patent Publication No. 2015-71670

[Summary of Invention]

[Technical Problem]

However, when underfilling and overmolding are performed simultaneously, sealing material-unentered portions (voids) may be left in the spaces between a plurality of the electronic components and the substrate, which makes it difficult to perform sufficient underfilling in a stable manner.
One of the objects of the present invention is, in sealing an electronic component mounting substrate including a substrate and a plurality of electronic components mounted on the substrate and having a space between an electronic component and the substrate, to suppress the formation of sealing material-unentered portions (voids) in the space between the electronic component and the substrate, and to provide a sealing method that enables to perform sufficient underfilling in a stable manner.

[Solution to Problem]

One aspect of the present invention relates to a method for sealing an electronic component mounting substrate, the method comprising steps of: (a) preparing an electronic component mounting substrate including a substrate and a plurality of electronic components mounted on the substrate and having a space between an electronic component and the substrate; (b) placing a thermosetting sheet on the electronic component mounting substrate so as to be in contact with the electronic components; and (c) heat-molding the placed thermosetting sheet, to allow a melt of the thermosetting sheet to fill the space between the electronic component and the substrate and be cured, wherein when a distance between a center of the substrate and an optional point P on a frame line that surrounds all of the plurality of electronic components and minimizes a surrounded area is denoted by Lp, a distance Lq between the center of the substrate and a point Q at which a straight line passing through the point P and the center of the substrate intersects with an outer periphery of the thermosetting sheet is 0.9Lp or more.
Another aspect of the present invention relates to a thermosetting sheet for use in the above-described method for sealing an electronic component mounting substrate, the thermosetting sheet having a layer constituted of a resin composition having a maximum value of tan $\delta$ (loss tangent) of 3 or more as measured at a measurement temperature of 125 °C for a measurement time of 0 to 100 seconds.

[Advantageous Effects of Invention]

According to the above aspects of the present invention, in sealing an electronic component mounting substrate including a substrate and a plurality of electronic components mounted on the substrate and having a space between an electronic component and the substrate, sealing material-unentered portions (voids) are unlikely to be formed in the space between the electronic component and the substrate, and sufficient underfilling can be performed in a stable manner.

While the novel features of the invention are set forth particularly in the appended claims, the invention, both as to organization and content, will be better understood and appreciated, along with other objects and features thereof, from the following detailed description taken in conjunction with the drawings.

[Brief Description of Drawings]

[FIG. 1] A conceptual diagram of an example of an electronic component mounting substrate.

[FIG. 2] A diagram showing an example of each of a center C of the substrate, a frame line F that surrounds all of a plurality of electronic components and minimizes the surrounded area, an optional point P on the frame line, an outer periphery S of the thermosetting sheet, and an intersection Q between a straight line Lcp passing through the point P and the center C and the outer periphery S.

[FIG. 3] A process diagram of a method for sealing an electronic component mounting substrate.

[Description of Embodiments]

A method for sealing an electronic component mounting substrate according to an embodiment of the present invention includes steps of: (a) preparing an electronic component mounting substrate including a substrate and a plurality of electronic components mounted on the substrate and having a space between an electronic component and the substrate; (b) placing a thermosetting sheet on the electronic component mounting substrate so as to be in contact with the electronic components; and (c) heat-molding the placed thermosetting sheet, to allow a melt of the thermosetting sheet to fill the space between the electronic component and the substrate and be cured.

According to the sealing method of the present embodiment, an electronic component mounting substrate (hereinafter sometimes referred to as a "sealed body") including a substrate, electronic components mounted on the substrate, and a cured product of a resin composition sealing the electronic components can be obtained. Therefore, the sealing method according to the present embodiment is also a method for manufacturing an electronic component mounting substrate (sealed body) sealed with a cured product of a melt of a thermosetting sheet. The electronic component mounting substrate may be a single-sided sealed body in which only one side of the substrate is sealed with the cured product, or may be a double-sided sealed body in which both sides are sealed with the cured product.

The cured product may be a semi-cured (B-stage) product. The semi-cured (B-stage) product refers to a resin composition that is solid at room temperature, but has fluidity for a while when heated to a predetermined temperature or higher, and then loses fluidity as the curing reaction proceeds. Hereinafter, when a cured product is referred to, it encompasses a semi-cured product.

In the electronic component mounting substrate prepared in the step (a), a plurality of electronic components are connected, for example, by a flip-chip connection method to the substrate (specifically, to the electrodes provided on the substrate). In the flip-chip connection method, electronic components are mounted on the substrate by way of protrusion-like terminals arranged in arrays (sometimes called "bumps"). A plurality of bumps are provided on the surface facing the substrate of each electronic component. The bumps constitutes part of the electronic component. The spaces between the electronic components and the substrate are mostly occupied by the gaps between the bumps.

The thermosetting sheet used in the step (b) is a sealing material, which is a mold underfill material formed into a sheet. A thermosetting sheet has a property of being melted by heating, and then, cured. The thermosetting sheet is constituted of, for example, a thermosetting resin composition (hereinafter sometimes simply referred to as a "resin composition"). The resin composition includes a thermosetting resin, such as an epoxy resin.

The thermosetting sheet may be a semi-cured (B-stage) product of a thermosetting resin composition. Hereinafter, a cured product of the thermosetting resin composition or thermosetting sheet is also referred to as a sealing material with no differentiation from an uncured product.

In the step (c), the heat-molding of the thermosetting sheet is performed using a mold. The mold presses the thermosetting sheet placed on the electronic component mounting substrate so as to cover the plurality of electronic components, against the substrate. The mold is heated at any desired timing. Heating melts the thermosetting sheet, and the melt, while spreading over the surfaces of the electronic components, enters the spaces between the electronic components and the substrate and fills the gaps between the electronic components, and then, is cured. That is, underfill sealing and overmold sealing that seals the entire electronic components are performed all at once. Here, the overmold sealing means to seal at least the surfaces of the electronic components with a sealing material. The pressing surface of the mold may be covered with a release film.

In a typical overmold sealing, in the case of using a liquid sealing material, the sealing material is applied by potting at the center portion of a substrate having electronic components mounted thereon, which is then pressed with a mold and pushed against the substrate. In the case of using a thermosetting sheet or sheet-like sealing material, typically, like in the case of using a liquid sealing material, the thermosetting sheet smaller in size than the substrate is placed near the center of the substrate. This is to allow the melted sealing material to flow and wet-spread over the substrate, as the sealing material is pressed with a mold and pushed against the substrate. However, due to the plurality of electronic components mounted on the substrate, the flow of the melted sealing material tends to be restricted, failing to sufficiently wet-spread over the substrate in some cases, and the spaces between the electronic components and the substrate may fail to be filled with the melted sealing material.

To address this, in the present embodiment, a thermosetting sheet whose size and shape in a plan view are designed depending on a frame line that surrounds all of the plurality of electronic components and minimizes the surrounded area (hereinafter sometimes referred to as a "frame line F") is placed on the substrate. Specifically, the distance between the center of the substrate (hereinafter sometimes referred to as the "center C") and an optional point P on the frame line F is denoted by Lp. An intersection between the straight line passing through the point P and the center C (hereinafter sometimes referred to as the "straight line Lcp") and the outer periphery of the thermosetting sheet (hereinafter sometimes referred to as the "outer periphery S") is defined as a point Q. The distance (hereinafter sometimes referred to as "Lq") between the point Q and the center C is restricted to 0.9Lp or more. The distance Lq may be 0.91Lp or more, may be 0.93Lp or more, and may be 0.96Lp or more. Here, the Lp and the Lq may satisfy the above relationship in 70% or more and further in 90% or more of the length of the locus of the frame line F, and desirably, the Lp and the Lq satisfy the above relationship in 98% to 100%.

With the tolerance of the thermosetting sheet, the tolerance of the substrate, and further the tolerance of the mold taken into consideration, the Lq may be set to 1.0Lp or more. The substrate may be completely covered with the thermosetting sheet when viewed from above.

When the thermosetting sheet is circular in shape, the radius R of such a thermosetting sheet corresponds to the distance Lq. In this case, the distance Lq (radius R) and the maximum value MLp of the distance Lp satisfy the above relationship, such as $Lq \geq 0.9MLp$. Here, the MLp, which is the maximum value of the Lp, is a distance Lp when the point P is at a point farthest away from the center of the substrate, among all the points of the electronic components on the substrate.

That is, in the present embodiment, the thermosetting sheet is placed on the substrate so as to completely cover or mostly cover the plurality of electronic components when viewed from above. Even when the outer periphery S of the thermosetting sheet is more inward (closer to the center C) than the frame line F, the distance between the points P and Q is very small. In this case, more of the pressure energy imparted from the mold to the thermosetting sheet is utilized to allow a melt of the thermosetting sheet to fill the spaces between the electronic components and the substrate. Therefore, the spaces between the electronic components and the substrate are likely to be filled with the melt (i.e., sealing material-unentered portions are less likely to be formed), and sufficient underfilling can be performed in a stable manner. Such an effect is remarkable when a plurality of electronic components mounted on a large-scale substrate are sealed all at once by a packaging technology like panel level packaging (PLP) and wafer level packaging (WLP).

In the step (c), the pressure applied from the pressing surface of the mold to the thermosetting sheet (or its melt) may be, for example, 0.5 MPa or more and 15 MPa or less, and may be 2 MPa or more and 12 MPa or less. This can facilitate the entry of the melt into narrow spaces.

The upper limit of the distance Lq between the point Q and the center C is not particularly limited from the viewpoint of performing sufficient underfilling in a stable manner. However, considering the production cost and ease of handling of the thermosetting sheet, the Lq may be, for example, 1.45Lp or less, may be 1.2Lp or less, may be 1.1Lp or less, and may be 1.05Lp or less.

Heat molding of the thermosetting sheet may be performed in a reduced pressure atmosphere. In this case, a more favorable underfilled portion can be formed. The reduced pressure atmosphere may be any pressure atmosphere lower than the atmospheric pressure, but is preferably a pressure atmosphere of 10,000 Pa (pascal) or less, that is, 100 hectopascal (hPa) or less, may be 5,000 Pa (pascal) or less, and is desirably less than 500 Pa (5 hPa), more desirably less than 200 Pa (2 hPa).

In the sealed body obtained through the step (c), the cured product constitutes an underfilled portion that fills the spaces between the substrate and the electronic components, and an overmolded portion that seals the surfaces not facing the substrate of the electronic components. The structures of the underfilled portion and the overmolded portion are continuous to each other.

Here, that "the structures of the underfilled portion and the overmolded portion are continuous to each other" means that the underfilled portion and the overmolded portion are simultaneously formed with the same sealing material. That is, the cured products constituting the underfilled portion and the overmolded portion have the same composition. No boundary is observed between the underfilled portion and the overmolded portion even by a microscopic observation and the like, and there is no substantial difference in morphology (state of structure) between the underfilled portion and the overmolded portion.

The substrate may be of any kind, and includes, for example, a wafer, a panel, a glass substrate, a resin substrate, and a printed wiring board. Examples of the wafer include silicon wafers, sapphire wafers, and compound semiconductor wafers. Examples of the panel include plate-shaped members used for liquid crystal panels, organic (or inorganic) LED panels, and the like. Examples of the resin substrate include bismaleimide triazine substrates, polyimide substrates, and fluororesin substrates. The substrate itself may be an assembly of electronic components. The assembly of electronic components is, for example, an assembly of semiconductor chips before being diced into individual chips.

The electronic components may be an active device or a passive device. The electronic component may be a semiconductor device or may be other than that. The electronic component may be a semiconductor package, such as BGA (Ball grid array) and CSP (Chip size package). Specific examples of the electronic component include RFIC (Radio frequency identifier), chip multilayer LC filter, and dielectric filter, multilayer ceramic capacitor (MLCC).

It is desirable that the outer shape of the substrate is approximately corresponding to the outer shape of the thermosetting sheet. The outer shape of the substrate may be similar to the outer shape of the thermosetting sheet. For example, when the substrate has a circular outer shape, the thermosetting sheet may also have a circular outer shape. When the substrate has a rectangular outer shape, the thermosetting sheet may also have a rectangular outer shape. When the substrate, like an orientation flat wafer, has an approximate circular outer shape, the thermosetting sheet may have a circular outer shape. Also, 70% or more of the length of the locus of the outer periphery S of the thermosetting sheet may satisfy the relationship of similarity with the outer shape of the substrate.

The size of the electronic components is not particularly limited, but the area of the surfaces of the electronic components facing the substrate may be, for example, 1 mm$^2$ or more, or 3 mm$^2$ or more per one electronic component. The area of the surfaces of the electronic components facing the substrate may be, for example, 1600 mm$^2$ or less, or may be 2500 mm$^2$ or less per one electronic component. The size of the electronic components is determined as an average of the values measured for any plural number of (e.g., 10) electronic components on the substrate.

The height of each of the electronic components is not particularly limited, but may be, for example, 5 $\mu$m or more and 800 $\mu$m or less, and may be 10 $\mu$m or more and 600 $\mu$m or less. The height of each of the electronic components is, for example, the distance from the contact point between the bumps and the substrate to the highest point of the electronic component. In other words, according to the present embodiment, even with respect to a substrate with a plurality of tiny electronic components of about 5 $\mu$m in height mounted thereon, favorable underfill sealing and overmold sealing can be performed all at once.

The distance of a gap between the electronic components is not particularly limited, but may be, for example, 5 $\mu$m or more and 2000 $\mu$m or less, and may be 10 $\mu$m or more and 1000 $\mu$m or less. The distance of a gap between the electronic components is a distance measured between the outer peripheries closest to each other of adjacent electronic components (i.e., a gap interval). In other words, according to the present embodiment, even for a high-density mounting substrate with a gap interval of about 5 $\mu$m, favorable underfill sealing and overmold sealing can be performed all at once. The distance of a gap between the electronic components is determined as an average of the values measured for any number of pairs of (e.g., 10 pairs of) electronic components on the substrate.

The height of the space between the electronic component and the substrate may be, for example, 2 $\mu$m or more, 5 $\mu$m to 100 $\mu$m, or 10 $\mu$m or more and 80 $\mu$m or less. In other words, according to the present embodiment, even for a substrate having small bumps and having a space height of about 2 to 5 $\mu$m, favorable underfill sealing and overmold sealing can be performed all at once. The height of the space between the electronic component and the substrate may be, for example, 40 $\mu$m or less, and may be 15 $\mu$m or less. The height of the space between the electronic component and the substrate means the shortest distance between the surface facing the substrate of the electronic component and the substrate. The shortest distance is determined as an average of the values measured for any plural number of (e.g., 10) electronic components on the substrate.

In the electronic component mounting substrate (sealed body) sealed with a cured product of the thermosetting resin, the maximum thickness T of the cured product may be, for example, 1.2 mm or less, may be 1.0 mm or less, may be 0.8 mm or less, and may be 0.4 mm or less (i.e., 400 $\mu$m or less). According to the present embodiment, for example, even when forming a thin sealed body as above in packaging application, such as PLP and WLP, favorable underfill sealing and overmold sealing can be effectively performed all at once.

In the sealed body, the maximum thickness T of the cured product of the thermosetting resin composition is the maximum distance from the surface of the substrate to the surface opposite to the substrate of the cured product. The maximum thickness T is determined as an average of the values measured at any plural number of (e.g., 10) points on the substrate.

<Thermosetting sheet>

The thermosetting sheet for use in the method for sealing an electronic component mounting substrate may have a monolayer structure or a multilayer structure. The multilayer structure is a structure in which two or more layers having different compositions are stacked together.

The thermosetting resin composition constituting the thermosetting sheet may contain a solid component. The solid component may be either an inorganic material or an organic material. The solid component dispersed in the resin composition may be in any form, such as particulate, plate-like, and fibrous. Usually, the thermosetting resin composition contains an inorganic powder as a filler.

The thermosetting resin composition contains, for example, a thermosetting resin (principal resin), a filler, a curing agent, and/or a curing accelerator.

The principal resin is not particularly limited, but may include an epoxy resin, a phenolic resin, a silicone resin, a melamine resin, a urea resin, an alkyd resin, a polyurethane, and the like. Among them, an epoxy resin is particularly excellent in terms of heat resistance and cost. These may be used singly or in combination of two or more kinds.

As the epoxy resin, although not limited thereto, a bisphenol A-type epoxy resin, a bisphenol-F type epoxy resin, a bisphenol-AD type epoxy resin, a naphthalene-type epoxy resin, a biphenyl-type epoxy resin, a glycidylamine-type epoxy resin, an alicyclic epoxy resin, a dicyclopentadiene-type epoxy resin, a polyether-type epoxy resin, a silicone-modified epoxy resin, and the like can be used. These may be used singly or in combination of two or more kinds. Among them, preferred are a biphenyl-type epoxy resin, a naphthalene-type epoxy resin, a bisphenol A-type epoxy resin, a bisphenol F-type epoxy resin, a bisphenol AD-type epoxy resin, and like, and further preferred is a biphenyl-type epoxy resin because its melt has a low viscosity and it is excellent in moisture resistance.

As the phenol resin, although not limited thereto, a phenol novolac resin is preferred. Phenol novolac resins are condensed polymers of phenols or naphthols (e.g., phenol, cresol, naphthol, alkylphenol, bisphenol, terpene phenol, naphthol) and formaldehyde. Specific examples thereof include phenol novolac resin, cresol novolac resin, aralkylphenol novolac resin, biphenylphenol novolac resin, terpenephenol novolac resin, $\alpha$-naphthol novolac resin, and $\beta$-naphthol novolac resin. Among them, in view of water resistance, preferred is a naphthol novolac resin. These may be used singly or in combination of two or more kinds.

As the curing agent for epoxy resins, in addition to the above phenol resins, an acid anhydride, an amine compound, and the like can be used. Examples of the acid anhydride include, but not limited to, hexahydrophthalic anhydride, alkylhexahydrophthalic anhydride, alkyltetrahydrophthalic anhydride, trialkyltetrahydrophthalic anhydride, methylnadic anhydride, and methylnorbomene-2,3-dicarboxylic acid. These may be used singly or in combination of two or more kinds.

Examples of the amine compound include, but not limited to, tetramethyl diaminodiphenylmethane, tetraethyl diaminodiphenylmethane, diethyl dimethyl diaminodiphenylmethane, dimethyl diamino toluene, diamino dibutyl toluene, diamino dipropyl toluene, diaminodiphenyl sulfone, diaminoditolyl sulfone, diethyl diamino toluene, bis(4-amino-3-ethylphenyl)methane, and polytetramethyleneoxide-di-p-aminobenzoate.

As the curing accelerator, although not limited thereto, an imidazole-based curing accelerator, a phosphorus-based curing accelerator, a phosphonium salt-based curing accelerator, bicyclic amidines and derivatives thereof, an organic metal complex, a ureamodified polyamine, and the like can be used. The curing accelerator is preferably a latent curing accelerator. Examples of the latent curing accelerator include imidazole-based curing accelerator, and phosphorus-based curing accelerator. A particularly preferred latent curing accelerator is an encapsulated imidazole-modified product (microcapsule-type curing accelerator).

The thermosetting resin composition may further contain an additive. As the additive, for example, a silane coupling agent, a carbon black, a defoaming agent, a leveling agent, a pigment, a stress-buffering agent, a pre-gelling agent, an ion scavenger, and the like can be used, but not limited thereto. There are various kinds of silane coupling agents, and depending on its kind, the properties of the resin composition (e.g., viscosity at room temperature) can vary. Therefore, a desirable silane coupling agent is selected as appropriate. The silane coupling agent has a hydrolyzable group (e.g., alkoxy group, hydroxyl group), and may further has an alkyl group, an aliphatic or aromatic amino group (e.g., phenylamino group), an acrylic group, a methacrylic group, and the like.

As the filler, silica (e.g., fused silica, crystalline silica), quartz glass powder, calcium carbonate, aluminum hydroxide, and the like can be used. Among them, silica is preferred, and fused silica is more preferred.

The content of the filler in the thermosetting resin composition is not particularly limited, but may be, for example, 35 mass% or more, may be 50 mass% or more, may be 60 mass% or more, and may be 70 mass% or more. Although the upper limit is not limited, the content of the solid component in the thermosetting resin composition is, for example, 90 mass% or less, and may be 85 mass% or less.

The average particle diameter of the filler is determined as appropriate, depending on the thickness of the space between each of the electronic components and the substrate, within a range smaller than that thickness, but is, for example, 0.5 $\mu$m or more, may be 1 $\mu$m or more, and may be 2 $\mu$m or more. The average particle diameter of the filler may be, for example, 10 $\mu$m or less, and may be 5 $\mu$m or less. The average particle diameter of the filler is a median diameter (D50) at 50% cumulative volume in a volume particle size distribution.

The maximum particle diameter of the filler is desirably smaller than the distance of a gap between the electronic components (the distance measured between the outer peripheries closest to each other of adjacent electronic components) and the height of the space between the electronic component and the substrate, and can be selected as appropriate depending on the above distance and thickness. The maximum particle diameter (Dmax) of the filler may be, for example, 35 $\mu$m or less, and may be 25 $\mu$m or less.

The average particle diameter (D50) and the maximum particle diameter (Dmax) of the filler can be measured by a laser diffraction scattering method using a laser diffraction particle size distribution analyzer.

The thickness of the thermosetting sheet is not particularly limited, but may be, for example, 100 $\mu$m or more, may be 200 $\mu$m or more, and may be 400 $\mu$m or more. The thickness of the thermosetting sheet is, for example, 1000 $\mu$m or less, and may be 800 $\mu$m or less.

The thermosetting sheet may have, for example, a monolayer structure constituted of a resin composition having a maximum value of tan $\delta$ (loss tangent) of 3 or more as measured at a measurement temperature of 125 °C for a measurement time of 0 to 100 seconds, and may have a multilayer structure having layers each constituted of a resin composition having such a maximum value of 3 or more. The resin composition having a maximum value of tan $\delta$ (loss tangent) of 3 or more as described above (hereinafter sometimes referred to as the "resin composition A") can exhibit excellent entering ability during performing mold underfill, even when the space between the electronic component and the substrate is narrow. The maximum value of tan $\delta$ (loss tangent) as above of the thermosetting sheet may be 5 or more, and may be 7 or more.

The tan $\delta$ (loss tangent) is roughly related to the ratio between the elastic property and the viscous property in the resin composition A. When performing underfilling with respect to electronic components like semiconductor chips in which the electrode-to-electrode distance is narrow, only with a low viscosity, the entering ability into the deepest part tends to be insufficient. In order to satisfy the entering ability into the deepest part, the elastic force, which is a force to push the entered material from behind, is also required. The thermosetting sheet containing a layer A made of a resin composition A having the above maximum value of tan $\delta$ (loss tangent) exhibits excellent entering ability during performing mold underfill with respect to electronic components in which the electrode-to-electrode distance is narrow.

The thermosetting sheet may further have a layer B constituted of a resin composition B. The layer B may satisfy a formula: $40{,}000 \le \alpha \times E' \le 250{,}000$ [Pa/K]. Here, $\alpha$ represents a coefficient of thermal expansion [ppm/K] at 80 °C or less (e.g., 50 °C to 70 °C) of a cured product obtained by heating and curing the resin composition B at 175 °C for 1 hour. E' represents a storage modulus [GPa] at 25 °C of such a cured product.

The electronic components may cause shape changes during curing of the resin composition. On the other hand, a thermosetting sheet having a layer B made of a resin composition B satisfying the above formula can easily follow the shape changes of the electronic components, and can highly suppress the warpage, while exhibiting excellent entering ability. Specifically, the coefficient of thermal expansion indicates the percentage by which the length of the sheet changes with the increase of temperature, and the storage modulus indicates the stiffness of the sheet. When the above formula is satisfied, for example, when the coefficient of thermal expansion $\alpha$ is high, the storage modulus E' is reduced, and the stiffness of the sheet can be reduced. By that, the sheet can easily follow the changes in the shape of the electronic components, allowing the stress due to the heat of the electronic components to be relaxed to a greater extent.

The ratio B/A of the thickness of the layer B to the thickness of the layer A is, for example, 0.1 to 80, preferably 0.3 to 20. In this case, more excellent sealing performance can be exhibited with respect to electronic components in which the electrode-to-electrode distance is narrow. In addition, warpage of the sealed electronic components can be highly suppressed.

In the multilayer structure, it is desirable that a layer constituted of a resin composition A having a maximum value of tan $\delta$ (loss tangent) of 3 or more is formed at the outermost layer. The layer A is placed so as to be in direct contact with the electronic components and substrate. In this case, the thickness of the layer A is, for example, 10 $\mu$m or more, may be 20 $\mu$m or more, and may be 40 $\mu$m or more. The thickness of the layer A is, for example, 500 $\mu$m or less, may be 400 $\mu$m or less, and may be 300 $\mu$m or less. The thickness of the layer B may be 50 $\mu$m or more, may be 100 $\mu$m or more, and may be 200 $\mu$m or more. The thickness of the layer B may be 800 $\mu$m or less, may be 700 $\mu$m or less, and may be 600 $\mu$m or less. By setting the thickness of the layer B within the above range, it becomes easier to suppress the warpage of the electronic components.

The maximum value of tan $\delta$ of the thermosetting resin composition can be controlled by the content of the filler, the kind of the thermosetting resin and the curing agent, and others. For example, increasing the content of the filler can decrease the maximum value, and decreasing the content of the filler can increase the maximum value. The maximum value of tan $\delta$ can be set to 3 or more by using a thermosetting resin, such as a crystalline epoxy resin and a liquid epoxy resin that becomes less viscous when heated, or by using a curing agent with low viscosity, such as a low-molecular-weight phenolic resin, a crystalline acid anhydride, and a liquid phenolic resin.

The maximum value of tan δ of the thermosetting resin composition may be a value measured using a test piece of 25 mmϕ in diameter, with a viscoelastometer (e.g., ARES-LS2 available from TA Instruments Corporation), under the conditions of a measurement temperature of 125 °C, a measurement time of 0 to 100 seconds, and a frequency of 1 Hz. The test piece is cut out from an uncured or semi-cured (B-stage) thermosetting sheet and used.

The storage modulus of the cured product of the thermosetting sheet as a whole is, for example, 3 GPa or more, and may be 5 GPa or more, and may be, for example, 40 GPa or less, and may be 30 GPa or less.

The storage modulus of a cured product of the thermosetting sheet is measured by the following procedure. First, a measurement sample having a length of 50 mm, a width of 10 mm, and a thickness of 2 mm is prepared from a cured product of the thermosetting sheet (thermosetting resin composition). The cured product used here is prepared by heating and curing a thermosetting sheet at 175 °C for 1 hour. Next, with the measurement sample set on a jig for bending measurement, the bending storage modulus in a temperature range of -50 to 300 °C is measured under the conditions of a frequency of 1 Hz and a temperature elevation rate of 2.5 °C/min, using a viscoelastometer (DMA6100, available from Hitachi High-Tech Science Corporation). The storage modulus at 25 °C is read from the measurement result.

In measuring the thermal expansion degree of the thermosetting resin composition, a measurement sample having a length of 20 mm, a width of 5 mm, and a thickness of 5 $\mu$m is prepared from a cured product obtained by heating the resin composition at 175 °C for 1 hour. With the measurement sample set on a compression measurement jig of a thermomechanical analyzer (TMA7100), the measurement is performed in a temperature range of -50 to 300 °C under the conditions of a load of 5 g and a temperature elevation rate of 2.5 °C/min. For example, the thermal expansion coefficient $\alpha$ [ppm/K] is calculated from the expansion degree at 50 °C to 70 °C.

The thermosetting sheet may contain a thermoplastic resin. Examples of the thermoplastic resin include silicone oils, such as non-reactive silicone oil and reactive silicone oil, acrylic resins, phenoxy resins, polyolefins, polyurethanes, blocked isocyanates, polyethers, polyesters, polyimides, polyvinyl alcohols, butyral resins, polyamides, vinyl chlorides, cellulose, thermoplastic epoxy resins, and thermoplastic phenolic resins. In particular, an acrylic resin is preferred.

The amount of the thermoplastic resin contained in the thermosetting sheet is, for example, per 100 parts by mass of the thermosetting resin (principal resin, such as an epoxy resin), preferably 5 parts by mass or more and 65 parts by mass or less, more preferably 10 parts by mass or more and 50 parts by mass or less.

<Method for producing thermosetting sheet having multilayer structure>

A thermosetting sheet having a multilayer structure can be produced by forming each layer separately by, for example, a calendar film-forming method, a casting film-forming method, an inflation extrusion method, a T-die extrusion method, a dry lamination method, and the like, and then laminating them together, or using a co-extrusion method and the like. A thermosetting sheet may be formed on a base material, and the base material may be peeled off before use. The base material that can be used include, but are not limited to, a plastic film, paper, nonwoven fabric, and metal. Examples of the plastic film include polyolefin-based film, vinyl halide polymer-based film, acrylic resin-based film, rubber-based film, cellulose-based film, polyester-based film, polycarbonate-based film, polystyrene-based film, polyphenylene sulfide-based film, and cycloolefin polymer-based film. Also, a base material having been subjected to release treatment with silicone or the like can be used. The thickness of the base material is not particularly limited, but is preferably 500 $\mu$m or less.

In the following, the sealing method according to one embodiment of the present invention will be described more specifically with reference to the drawings.

Step (a)

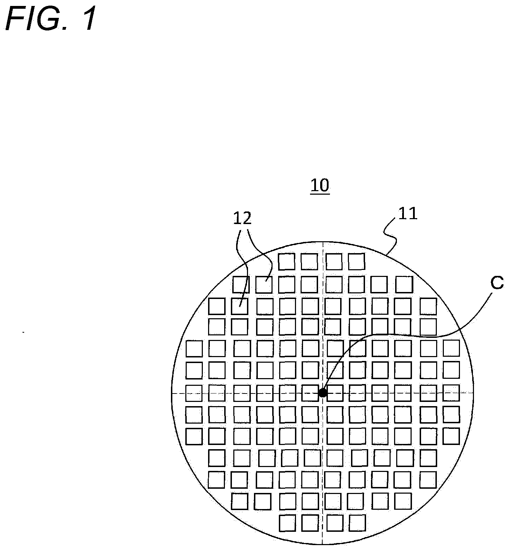

First, a substrate with a plurality of electronic components mounted thereon is prepared. A space is provided between an electronic component and the substrate. FIG. 1 is a conceptual diagram of an example of an electronic component mounting substrate 10. A substrate 11 included in the electronic component mounting substrate 10 is a notched wafer having a circular outer shape. On a surface of the substrate 11, a plurality of rectangular semiconductor chips are mounted as electronic components 12. FIG. 1 is a conceptual diagram and does not necessarily reflect the actual size of the electronic components.

Step (b)

Next, a thermosetting sheet 20 is placed on the substrate 11 so as to be in contact with the electronic components 12. Here, an optional point on a frame line F that surrounds all of the plurality of electronic components 12 and minimizes the surrounded area is referred to as a point P. The distance between the point P and the center C of the substrate is denoted by Lp. The point at which a straight line Lcp passing through the point P and the center C intersects with an outer periphery S is referred to as a point Q. At this time, a distance Lq between the point Q and the center C of the substrate 11 satisfies 0.9Lp or more.

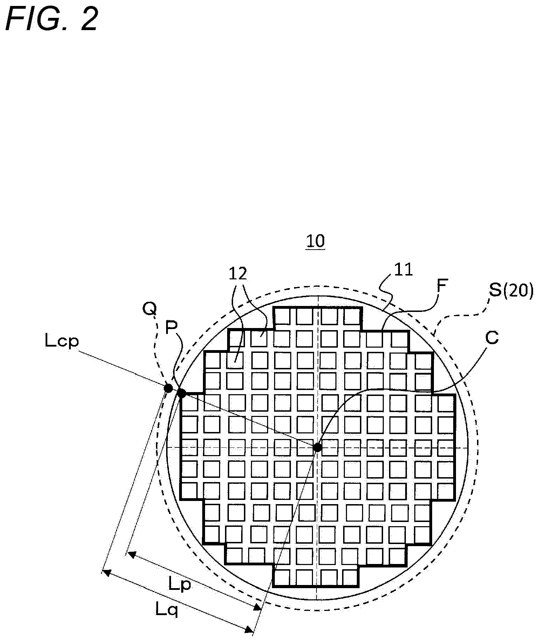

FIG. 2 is a diagram showing an example of each of the center C of the substrate 11, the frame line F that surrounds all of the plurality of electronic components 12 and minimizes the surrounded area, the optional point P on the frame line F, the outer periphery S of the thermosetting sheet 20, and the intersection Q between the straight line Lcp passing through the point P and the center C and the outer periphery S. The frame line F is indicated by a thicker solid line. The outer periphery S of the thermosetting sheet 20 is indicated by a broken line. In the illustrated example, Lq > Lp, but in some cases, Lq ≤ Lp. Also, in the illustrated example, the size of the thermosetting sheet 20 is larger than that of the substrate 11 when viewed from above, but the size of the thermosetting sheet 20 may be equal to or smaller than the size of the substrate 11.

Step (c)

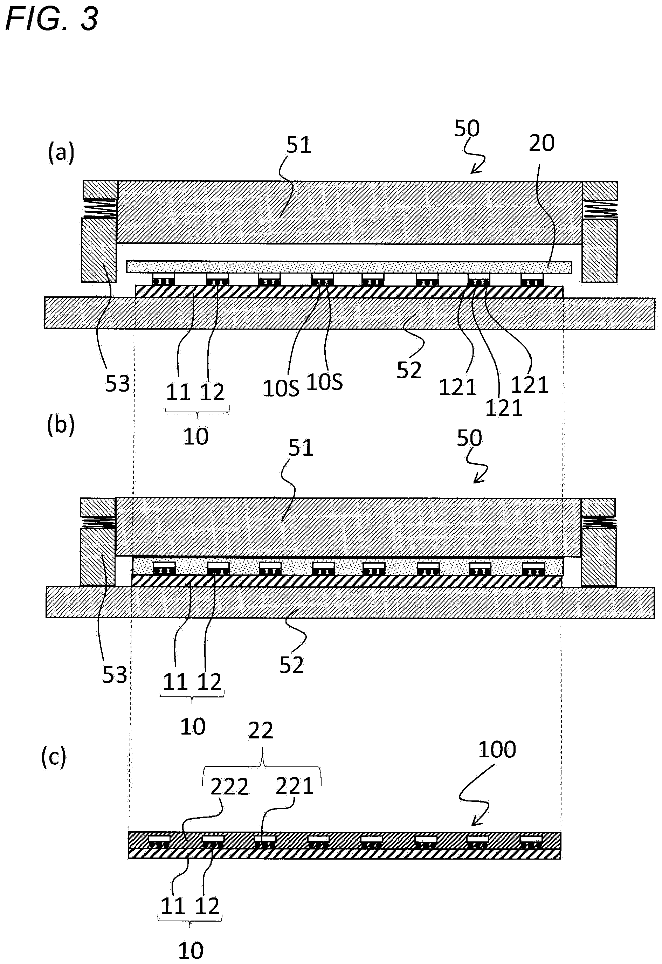

Next, the thermosetting sheet 20 placed on the electronic component mounting substrate 10 is heat-molded, to allow a melt of the thermosetting sheet 20 to fill the spaces between the electronic components 12 and the substrate 11 and the melt to be cured. FIG. 3 is a process diagram of a method for sealing the electronic component mounting substrate 10.

Specifically, as shown in FIG. 3(a), the electronic component mounting substrate 10 is set on a compression molding machine 50. The compression molding machine 50 has an upper mold 51, a lower mold 52, and a flange portion 53 which is fixed to the circumferential rim of the upper mold 51 via an elastic member, such as a spring, and serves as part of the mold. The upper mold 51 has a flat pressing surface that presses the thermosetting sheet 20. The pressing surface of the upper mold 51, the substrate mounting surface of the lower mold 52, the flange portion 53, and the like may be covered with a release film.

The plurality of electronic components 12 are each connected via bumps 121 to the surface of the substrate 11. Spaces 10S are provided between the surface facing the substrate 11 of each of the electronic components 12 and the substrate 11. The spaces 10S are mostly occupied by the gaps between bumps.

In the heat molding process, as shown in FIG. 3(b), the thermosetting sheet 20 placed on the electronic component mounting substrate 10 is covered with the pressing surface of the mold, and the thermosetting sheet 20 is compressed while being heated. At this time, part of a melt of the thermosetting sheet 20 enters the spaces 10S, and the curing reaction of the melt proceeds.

At least one of the lower mold 52 and the upper mold 51 is heated to a temperature at which the curing reaction of the melt of the thermosetting sheet 20 proceeds. The curing reaction of the melt proceeds, to form an underfilled portion 221 and an overmolded portion 222 simultaneously. As a result, a sealed body 100 of the electronic component mounting substrate 10 sealed with a cured product 22 can be obtained.

At least part of the step (c) may be carried out under atmospheric pressure or under reduced pressure as already mentioned. When heat molding is performed under reduced pressure, air is sucked from the space in which the compression molding machine 50 is installed.

The heating temperature is, for example, 80 to 200 °C, and may be 100 to 180 °C. The heating time is, for example, 30 seconds to 30 minutes, and may be 2 minutes to 20 minutes.

The sealed body 100 unloaded from the compression molding machine 50 may be further subjected to post-mold curing (post-curing). Post-mold curing may be performed, for example, at 100 to 180 °C for about 30 minutes to 3 hours.

[Examples]

The present invention will be more specifically described below based on Examples and Comparative Examples, but the present invention is not limited to the following Examples.

«Examples 1 to 10 and Comparative Examples 1 and 2»

<Production of thermosetting sheet>

(1) A thermosetting resin (epoxy resin), a curing agent, a filler (fused silica: average particle diameter (D50) 2.8 μm, maximum particle diameter (Dmax) 10 μm), a carbon black (average particle diameter 24 nm), a silane coupling agent A (KBM503 : available from Shin-Etsu Silicone), an ion scavenger (inorganic ion-exchange agent), a curing accelerator, and others were mixed in a mixing ratio as shown in Table 1, and kneaded with a roll kneader, to prepare

**EP 4 287 250 A1**

a thermosetting resin composition. The units of all the numerical values in the table are parts by mass.

(2) Next, the obtained thermosetting resin composition was applied in a sheet form onto a release treatment film by a T-die extrusion method under the condition of 100 °C, to form a thermosetting sheet (sealing material) having a thickness of 500 $\mu$m. The release treatment film used here was a 50-$\mu$m-thick polyethylene terephthalate film having been subjected to silicone release treatment.

[Evaluation]

<Measurement of maximum value of tan $\delta$ (loss tangent)>

The tan $\delta$ of the thermosetting sheets obtained above was measured. The measurement was performed using a test piece of 25 mm$\phi$ in diameter of each sheet, with a viscoelastometer (e.g., ARES-LS2 available from TA Instruments Corporation), under the conditions of a measurement temperature of 125 °C, a measurement time of 0 to 100 seconds, and a frequency of 1 Hz. The results found that the maximum value of tan $\delta$ (loss tangent) was 3 or more in all of the thermosetting sheets.

<Mold underfill test>

(When the substrate is circular (Examples 1, 3, 5, 7 and 9, and Comparative Example 1))

Five electronic components for evaluation (TEGs) were mounted on a glass substrate of 300 mm$\phi$ in diameter having a circular outer shape, to prepare a sample electronic component mounting substrate for evaluation. The electronic components were placed at the center C of the substrate and at four equiangular positions (0°, 90°, 180° and 270°) with respect to the center C, so that the maximum value of the distance between the point P of each electronic component and the center C of the substrate satisfied Lp = 140 mm.

(When the substrate is rectangular (Examples 2, 4, 6, 8 and 10, and Comparative Example 2))

Five electronic components for evaluation (TEGs) were mounted on a glass substrate of 240 mm long and 74 mm wide having a rectangular outer shape, to prepare a sample electronic component mounting substrate for evaluation. The electronic components were placed at the center C of the substrate and at four equivalent positions at four corners, so that the maximum value of the distance between the point P of each electronic component and the center C of the substrate satisfied Lp = 110 mm.

In the TEG, the bump height corresponding to the height of the space between the electronic component and the substrate was 30 $\mu$m, the dimensions were 25 mm by 25 mm by 300 $\mu$m (the height of the electronic component including the bumps was 330 $\mu$m), the bump size was 20 $\mu$m, and the center-to-center pitch of the bumps was 40 $\mu$m.

A thermosetting sheet similar in shape (circular or rectangular) to the substrate whose Lq was as shown in Table 1 was placed on the sample so as to be in contact with the electronic components, with the center of the substrate aligned with the center of the thermosetting sheet, and the thermosetting sheet was heat-molded under the following conditions.

Molding pressure: 5 MPa
Molding temperature: 125 °C
Molding time: 10 minutes
Minimum degree of vacuum: 200 Pa
Post-mold curing (post-curing): 175 °C / 1 hour

The state (entering ability) of the underfilled portion filling the spaces between the substrate and the electronic components was visually checked. The observation was made directly from the back side of the glass substrate, and the evaluation was made according to the following criteria by the size of the unentered portions (voids) of the cured product of the sealing material. The size of the void was evaluated using the largest among those of the five electronic components for evaluation (TEGs). The results are shown in Table 1.

Excellent (Exc.): The size of the void size was 500 $\mu$m or less.
Good: The size of the void was more than 500 $\mu$m and 1000 $\mu$m or less.
Poor: The size of the void was more than 1000 $\mu$m.

[Table 1]

| | Kind | Dmax (μm) | D50 (μm) | Com. Ex. | | Ex. | | | | | | | | | |
|---|---|---|---|---|---|---|---|---|---|---|---|---|---|---|---|
| | | | | 1 | 2 | 1 | 2 | 3 | 4 | 5 | 6 | 7 | 8 | 9 | 10 |
| thermosetting resin | biphenyl-type epoxy resin | | | 100 | 100 | 100 | 100 | 100 | 100 | 100 | 100 | 100 | 100 | 100 | 100 |
| curing agent | solid phenol novolac | | | 55 | 55 | 55 | 55 | 55 | 55 | 55 | 55 | 55 | 55 | 55 | 55 |
| filler | fused silica | 10 | 2.8 | 390 | 390 | 390 | 390 | 390 | 390 | 390 | 390 | 390 | 390 | 390 | 390 |
| carbon black | | | | 2 | 2 | 2 | 2 | 2 | 2 | 2 | 2 | 2 | 2 | 2 | 2 |
| silane coupling agent A | | | | 2 | 2 | 2 | 2 | 2 | 2 | 2 | 2 | 2 | 2 | 2 | 2 |
| ion scavenger | | | | 5 | 5 | 5 | 5 | 5 | 5 | 5 | 5 | 5 | 5 | 5 | 5 |
| curing accel-erator | triarylphos-phine -based compound | 10 | 1.5 | 3 | 3 | 3 | 3 | 3 | 3 | 3 | 3 | 3 | 3 | 3 | 3 |
| | filler content [mass%] | | | 70 | 70 | 70 | 70 | 70 | 70 | 70 | 70 | 70 | 70 | 70 | 70 |
| Evaluation | 100Lq/Lp [%] | | | 89 | 89 | 91 | 91 | 93 | 93 | 96 | 96 | 100 | 100 | 104 | 104 |
| | substrate shape | | | circular | rectangular | circular | rectangular | circular | rectangular | circular | rectangular | circular | rectangular | circular | rectangular |
| | entering ability | | | Poor | Poor | Good | Good | Good | Good | Exc. | Exc. | Exc. | Exc. | Exc. | Exc. |

«Examples 11 to 37»

<Production of thermosetting sheet>

A thermosetting resin (epoxy resin), a curing agent, a filler, a thermoplastic resin, a carbon black (average particle size 24 nm), a silane coupling agent A (KBM503 : available from Shin-Etsu Silicone) or B (KBM573: available from Shin-Etsu Silicone), an ion scavenger (inorganic ion-exchange agent), a curing accelerator, and others were mixed in a mixing ratio as shown in Tables 2 and 3, and kneaded with a roll kneader to prepare a thermosetting resin composition, which was formed into a sheet. Thermosetting sheets (sealing materials) each having a thickness of 500 $\mu$m were produced. The units of all the numerical values in the tables are parts by mass.

Samples of an electronic component mounting substrate for evaluation with electronic components mounted on a circular substrate similar to that in Example 1 were prepared. A circular thermosetting sheet whose Lq was 1.0Lp was placed on each sample so as to be in contact with the electronic components, with the center of the substrate aligned with the center of the thermosetting sheet, and the thermosetting sheet was heat-molded in a manner similar to that in the above Examples, and evaluated similarly. The results are shown in Tables 2 and 3. The maximum value of tan $\delta$ (loss tangent) was 3 or more in all of the thermosetting sheets.

«Examples 38 to 45»

<Production of thermosetting sheet>

(Layer A)

A thermosetting resin composition prepared in a manner similar to that in Example 1 was applied in a sheet form onto a release treatment film as used in the above, by a T-die extrusion method under the condition of 100 °C, to produce a thermosetting sheet (sealing material) having a thickness of 150 $\mu$m.

(Layer B)

A thermosetting resin (epoxy resin), a curing agent, a thermoplastic resin, a filler (fused silica: average particle diameter (D50) 4 $\mu$m, maximum particle diameter (Dmax) 20 $\mu$m), a carbon black (average particle size 24 nm), a silane coupling agent A (KBM503 : available from Shin-Etsu Silicone), an ion scavenger (inorganic ion-exchange agent), a curing accelerator, and others were mixed in a mixing ratio as shown in Table 4, and kneaded with a roll kneader, to prepare a thermosetting resin composition B. The units of all the numerical values in the table are parts by mass.

Next, the resultant thermosetting resin composition was applied in a sheet form onto a release treatment film as used in the above, by a T-die extrusion method under the condition of 100 °C, to produce a thermosetting sheet (sealing material) having a thickness of 350 $\mu$m (layer B, sealing material).

The layer A and the layer B prepared above were stacked so as to be in contact with each other, and laminated at a temperature of 60 °C with a laminator, to prepare a thermosetting sheet having a two-layered structure. In Examples 38 to 45, the layer A was common.

Samples of an electronic component mounting substrate for evaluation with electronic component mounted on a circular substrate similar to that in Example 1 were prepared. A circular thermosetting sheet whose Lq was 1.0Lp was placed on each sample so as to be in contact with the electronic components, with the center of the substrate aligned with the center of the thermosetting sheet, and the thermosetting sheet was heat-molded in a manner similar to that in the above Examples, and evaluated similarly. The results are shown in Table 4. The maximum value of tan $\delta$ (loss tangent) of the layer A was 3 or more in all of the thermosetting sheets. The $\alpha \times$ E' value of the layer B satisfied 40,000 $\leq \alpha \times$ E' $\leq$ 250,000 [Pa/K].

[Table 2]

| | Kind | Dmax (μm) | D50 (μm) | 11 | 12 | 13 | 14 | 15 | 16 | 17 | 18 | 19 | 20 | 21 | 22 |
|---|---|---|---|---|---|---|---|---|---|---|---|---|---|---|---|
| thermosetting resin | biphenyl-type epoxy resin | | | 100 | 100 | 100 | 100 | 100 | 100 | 100 | 100 | | | | |
| | bisphenol A-type epoxy resin | | | | | | | | | | | 100 | | | |
| | bisphenol F-type epoxy resin | | | | | | | | | | | | 100 | | |
| | naphthalene-type epoxy resin | | | | | | | | | | | | | 100 | |
| | glycidylamine-type epoxy resin | | | | | | | | | | | | | | 100 |
| | phenol novolac-type epoxy resin | | | | | | | | | | | | | | |
| | dicyclopentadiene-type epoxy resin | | | | | | | | | | | | | | |
| | polyglycol modified-type epoxy resin | | | | | | | | | | | | | | |
| curing agent | solid phenol novolac | | | 55 | 55 | 55 | 55 | 55 | 55 | 55 | 55 | 57 | 55 | 75 | 108 |
| | solid phenol | | | | | | | | | | | | | | |
| | liquid phenol novolac | | | | | | | | | | | | | | |
| | liquid acid anhydride | | | | | | | | | | | | | | |
| | solid acid anhydride | | | | | | | | | | | | | | |
| filler | fused silica | 20 | 7.2 | | | | | | | | 500 | | | | |
| | | 10 | 2.8 | 70 | 170 | 500 | 650.0 | 810.0 | | | | 390 | 510 | 390 | 560 | 660 |
| | | 5 | 1.8 | | | | | | 320 | | | | | | |
| | | 5 | 0.3 | | | | | | 60 | | | | | | |
| | | 5 | 0.1 | | | | | | 10 | | | | | | |

(continued)

| | Kind | Dmax (μm) | D50 (μm) | 11 | 12 | 13 | 14 | 15 | 16 | 17 | 18 | 19 | 20 | 21 | 22 |
|---|---|---|---|---|---|---|---|---|---|---|---|---|---|---|---|
| thermoplastic resin | acrylic | | | | | | | | | | | | | | |
| | ester-based | | | | | | | | | | | | | | |
| | silicone-based | | | | | | | | | | | | | | |
| | polyslycol-based | | | | | | | | | | | | | | |
| carbon black | | | | 2 | 2 | 2 | 2 | 2 | 2 | 2 | 2 | 2 | 2 | 2 | 2 |
| silane coupling agent A | | | | 2 | 2 | 2 | 2 | 2 | 2 | 2 | 2 | 2 | 2 | 2 | 2 |
| ion scavenger | | | | 5 | 5 | 5 | 5 | 5 | 5 | 5 | 5 | 5 | 5 | 5 | 5 |
| curing accelerator | imidazole-based compound | 10 | 2 | | | | | | | | 3 | | | | |
| | triarylphosphine-based compound | 10 | 1.5 | 3 | 3 | 3 | 3 | 3 | 3 | 3 | | 3 | 3 | 3 | 3 |
| | filler content [mass%] | | | 30 | 50 | 75 | 80 | 83 | 70 | 75 | 70 | 75 | 70 | 75 | 75 |
| Evaluation | 100Lq/Lp [%] | | | 100 | 100 | 100 | 100 | 100 | 100 | 100 | 100 | 100 | 100 | 100 | 100 |
| | substrate shape | | | circular | circular | circular | circular | circular | circular | circular | circular | circular | circular | circular | circular |
| | entering ability | | | Exc. | Exc. | Exc. | Exc. | Exc. | Exc. | Exc. | Exc. | Exc. | Exc. | Exc. | Exc. |

[Table 3]

| | Kind | Dmax (μm) | D50 (μm) | 23 | 24 | 25 | 26 | 27 | 28 | 29 | 30 | 31 | 32 | 33 | 34 | 35 | 36 | 37 |
|---|---|---|---|---|---|---|---|---|---|---|---|---|---|---|---|---|---|---|
| thermosetting resin | biphenyl-type epoxy resin | | | | | | | | | | | | 100 | | 100 | 100 | 100 | 100 |
| | bisphenol A-type epoxy resin | | | | | | | | | | | | | | | | | |
| | bisphenol F-type epoxy resin | | | | | | | | | | | | | | | | | |
| | naphthalene-type epoxy resin | | | | | | | | | | | | | | | | | |
| | glycidylamine-type epoxy resin | | | | | | | | | | | | | 20 | | | | |
| | phenol novolac-type epoxy resin | | | 80 | | 70 | | 70 | 70 | 80 | 100 | 100 | | 70 | | | | |
| | dicyclopentadiene-type epoxy resin | | | | 80 | | 70 | | | | | | | | | | | |
| | polyglycol modified-type epoxy resin | | | 20 | 20 | 30 | 30 | 30 | 20 | 20 | | | | 10 | | | | |
| | modified bisphenol A-type epoxy resin | | | | | | | | 10 | | | | | | | | | |

(continued)

| Category | Kind | Dmax (μm) | D50 (μm) | 23 | 24 | 25 | 26 | 27 | 28 | 29 | 30 | 31 | 32 | 33 | 34 | 35 | 36 | 37 |
|---|---|---|---|---|---|---|---|---|---|---|---|---|---|---|---|---|---|---|
| curing agent | solid phenol novolac | | | 54 | 54 | 50 | 50 | 50 | 50 | 25 | 21 | 21 | 27 | | 55 | 55 | 55 | 55 |
| | solid phenol | | | | | | | | | 25 | | | | | | | | |
| | liquid phenol novolac | | | | | | | | | | 28 | | | | | | | |
| | liquid acid anhydride | | | | | | | | | | | 34 | | | | | | |
| | solid acid anhydride | | | | | | | | | | | | 91 | | | | | |
| filler | fused silica | 20 | 7.2 | | | | | | | | | | | | | | | |
| | | 10 | 2.8 | 390 | 390 | 390 | 390 | 390 | 380 | 380 | 380 | 390 | 540 | 340 | 520 | 520 | 560 | 560 |
| | | 5 | 1.8 | | | | | | | | | | | | | | | |
| | | 5 | 0.3 | | | | | | | | | | | | | | | |
| | | 5 | 0.1 | | | | | | | | | | | | | | | |
| thermoplastic resin | acrylic | | | | | | | | | | | | | | 5 | | | |
| | ester-based | | | | | | | | | | | | | | | 5 | | |
| | silicone-based | | | | | | | | | | | | | | | | 20 | |
| | polyglycol-based | | | | | | | | | | | | | | | | | 20 |
| carbon black | | | | 2 | 2 | 2 | 2 | 2 | 2 | 2 | 2 | 2 | 2 | 2 | 2 | 2 | 2 | 2 |
| silane coupling agent A | | | | 2 | 2 | 2 | 2 | | 2 | 2 | 2 | 2 | 2 | 2 | 2 | 2 | 2 | 2 |
| silane coupling agent B | | | | | | | | 2 | | | | | | | | | | |
| ion scavenger | | | | 5 | 5 | 5 | 5 | 5 | 5 | 5 | 5 | 5 | 5 | 5 | 5 | 5 | 5 | 5 |
| curing accelerator | imidazole-based compound | 10 | 2 | | | | | | | | | | | | | | | |
| | triarylphosphine-based compound | 10 | 1.5 | 3 | 3 | 3 | 3 | 3 | 3 | 3 | 3 | 3 | 3 | 3 | 3 | 3 | 3 | 3 |

| | Kind | Dmax (μm) | D50 (μm) | 23 | 24 | 25 | 26 | 27 | 28 | 29 | 30 | 31 | 32 | 33 | 34 | 35 | 36 | 37 |
|---|---|---|---|---|---|---|---|---|---|---|---|---|---|---|---|---|---|---|
| | filler content [mass%] | | | 70 | 70 | 70 | 70 | 70 | 70 | 70 | 70 | 70 | 70 | 75 | 75 | 75 | 75 | 75 |
| Evaluation | 100Lq/Lp [%] | | | 100 | 100 | 100 | 100 | 100 | 100 | 100 | 100 | 100 | 100 | 100 | 100 | 100 | 100 | 100 |
| | substrate shape | | | circular | circular | circular | circular | circular | circular | circular | circular | circular | circular | circular | circular | circular | circular | circular |
| | entering ability | | | Exc. | Exc. | Exc. | Exc. | Exc. | Exc. | Exc. | Exc. | Exc. | Exc. | Exc. | Exc. | Exc. | Exc. | Exc. |

[Table 4]

| Kind | | 38 | 39 | 40 | 41 | 43 | 44 | 45 |
|---|---|---|---|---|---|---|---|---|
| thermosetting resin | biphenyl-type epoxy resin | 100 | | | | | | |
| | phenol novolac-type epoxy resin | | 80 | | | | | |
| | phenolphthalein-type epoxy resin | | | 80 | 70 | 70 | 70 | 70 |
| | polyether modified-type epoxy resin | | 20 | 20 | 20 | 20 | 20 | 20 |
| | modified bisphenol A-type epoxy resin | | | | 10 | 10 | 10 | 10 |
| curing agent | solid phenol novolac | 50 | 50 | 35 | 35 | 35 | 35 | 35 |
| thermoplastic resin | ester-based | | | | | 100 | | |
| | acrylic | | | | | | 100 | |
| | silicone-based | | | | | | | 20 |
| filler | fused silica | 680 | 680 | 870 | 870 | 760 | 760 | 990 |
| carbon black | | 2 | 2 | 2 | 2 | 2 | 2 | 2 |
| silane coupling agent A | | 2 | 2 | 2 | 2 | 2 | 2 | 2 |
| ion scavenger | | 5 | 5 | 5 | 5 | 5 | 5 | 5 |
| curing accelerator | triarylphosphine-based compound | 10 | 10 | 10 | 10 | 10 | 10 | 10 |
| filler content [mass%] | | 80 | 80 | 85 | 85 | 75 | 75 | 85 |
| layer A thickness [$\mu$m] | | 150 | 150 | 150 | 150 | 150 | 150 | 150 |
| layer B thickness [$\mu$m] | | 350 | 350 | 350 | 350 | 350 | 350 | 350 |
| ratio of thickness (B/A) | | 2.33 | 2.33 | 2.33 | 2.33 | 2.33 | 2.33 | 2.33 |
| Evaluation | 100Lq/Lp [%] | 100 | 100 | 100 | 100 | 100 | 100 | 100 |
| | substrate shape | circular | circular | circular | circular | circular | circular | circular |
| | entering ability | Exc. | Exc. | Exc. | Exc. | Exc. | Exc. | Exc. |

The curing conditions for forming a cured product for measurement of the storage elastic modulus, linear expansion coefficient, and the like are not limited to the above conditions, and may be set to, for example, at 150 °C for 1.5 hours, at 150 °C for 3 hours, at 175 °C for 1.5 hours, and the like, but not limited thereto.

Although the present invention has been described in terms of the presently preferred embodiments, it is to be understood that such disclosure is not to be interpreted as limiting. Various alterations and modifications will no doubt become apparent to those skilled in the art to which the present invention pertains, after having read the above disclosure. Accordingly, it is intended that the appended claims be interpreted as covering all alterations and modifications as fall within the true spirit and scope of the invention.

[Industrial Applicability]

According to the sealing method of the present invention, in sealing an electronic component mounting substrate including a substrate and a plurality of electronic components mounted on the substrate and having a space between an electronic component and the substrate, sealing material-unentered portions (voids) in the space between the electronic component and the substrate are unlikely to be formed, and thus, sufficient underfilling can be performed in a stable manner. The present invention is applicable, for example, for sealing of an integrated circuit and a large-scale integrated circuit used for IOT, automatic driving, and other technologies.

[Reference Signs List]

10: electronic component mounting substrate

10S: space
11: substrate
12: electronic component
121: bump

20: thermosetting sheet
22: cured product

221: underfilled portion
222: overmolded portion

50: compression molding machine

51: upper mold
52: lower mold
53: flange portion

F: frame line
C: center of substrate
Point P: optional point on frame line
Lp: distance between point P and center C
Lcp: straight line passing through point P and center C
S: outer periphery of thermosetting sheet
Q: intersection between Lcp and outer periphery S
Lq: distance between point Q and center C

**Claims**

1. A method for sealing an electronic component mounting substrate, the method comprising steps of:

(a) preparing an electronic component mounting substrate including a substrate and a plurality of electronic components mounted on the substrate and having a space between an electronic component and the substrate;
(b) placing a thermosetting sheet on the electronic component mounting substrate so as to be in contact with the electronic components; and
(c) heat-molding the placed thermosetting sheet, to allow a melt of the thermosetting sheet to fill the space between the electronic component and the substrate and be cured, wherein
when a distance between a center of the substrate and an optional point P on a frame line that surrounds all of the plurality of electronic components and minimizes a surrounded area is denoted by Lp,
a distance Lq between the center of the substrate and a point Q at which a straight line passing through the point P and the center of the substrate intersects with an outer periphery of the thermosetting sheet is 0.9Lp or more.

2. The method for sealing an electronic component mounting substrate according to claim 1, wherein the distance between the point Q and the center of the substrate is 1.45Lp or less.

3. The method for sealing an electronic component mounting substrate according to claim 1 or 2, wherein an outer shape of the substrate and an outer shape of the thermosetting sheet are similar to each other.

4.  The method for sealing an electronic component mounting substrate according to any one of claims 1 to 3, wherein

a height of each of the electronic components is 5 μm to 800 μm, and
a distance of a gap between the electronic components is 5 μm to 2000 μm.

5.  The method for sealing an electronic component mounting substrate according to any one of claims 1 to 4, wherein a height of the space between the electronic component and the substrate is 5 μm to 100 μm.

6.  The method for sealing an electronic component mounting substrate according to any one of claims 1 to 5, wherein the thermosetting sheet has a layer A constituted of a resin composition A having a maximum value of tan δ (loss tangent) of 3 or more as measured at a measurement temperature of 125 °C for a measurement time of 0 to 100 seconds.

7.  The method for sealing an electronic component mounting substrate according to claim 6, wherein

the thermosetting sheet further has a layer B composed of a resin composition B,
the layer B satisfying
a formula:

$$40,000 \leq \alpha \times E' \leq 250,000 \ [\text{Pa/K}],$$

where

$\alpha$ represents a thermal expansion coefficient [ppm/K] at 80 °C of a cured product obtained by heating and curing the resin composition B at 175 °C for 1 hour, and
E' represents a storage modulus [GPa] at 25 °C of the cured product.

8.  The method for sealing an electronic component mounting substrate according to claim 7, wherein a ratio B/A of a thickness of the layer B to the layer A is 0.1 to 80.

9.  The method for sealing an electronic component mounting substrate according to any one of claims 1 to 8, wherein the thermosetting sheet contains a filler.

10. The method for sealing an electronic component mounting substrate according to any one of claims 1 to 9, wherein a maximum particle diameter of the filler is 35 μm or less.

11. The method for sealing an electronic component mounting substrate according to any one of claims 1 to 10, wherein a content of the filler in the thermosetting sheet is 30 to 85 mass%.

12. The method for sealing an electronic component mounting substrate according to any one of claims 1 to 11, wherein the thermosetting sheet is circular in shape.

13. A thermosetting sheet for use in the method for sealing an electronic component mounting substrate according to claim 6.

*FIG. 1*

# FIG. 2

# FIG. 3

(a)

(b)

(c)

## INTERNATIONAL SEARCH REPORT

| International application No. |
|---|
| **PCT/JP2022/003123** |

**A. CLASSIFICATION OF SUBJECT MATTER**

*H01L 23/29*(2006.01)i; *H01L 23/31*(2006.01)i; *H01L 21/56*(2006.01)i
FI: H01L21/56 R; H01L23/30 R

According to International Patent Classification (IPC) or to both national classification and IPC

**B. FIELDS SEARCHED**

Minimum documentation searched (classification system followed by classification symbols)

H01L23/29; H01L23/31; H01L21/56

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2015-216229 A (NITTO DENKO CORP.) 03 December 2015 (2015-12-03) paragraphs [0028]-[0039], [0052], [0054], [0068], [0204]-[0211] | 1-5, 9-12 |
| Y | | 6-8, 13 |
| P, Y | WO 2021/029259 A1 (NAGASE CHEMTEX CORP.) 18 February 2021 (2021-02-18) paragraphs [0020], [0021], [0060], [0061], [0063], [0068] | 6-8, 13 |
| A | JP 2012-59743 A (NITTO DENKO CORP.) 22 March 2012 (2012-03-22) entire text, all drawings | 1-13 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **29 March 2022** | **12 April 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/003123**

| Patent document cited in search report | | | Publication date (day/month/year) | Patent family member(s) | | | Publication date (day/month/year) |
|---|---|---|---|---|---|---|---|
| JP | 2015-216229 | A | 03 December 2015 | CN 105849879 A paragraphs [0077]-[0090], [0105], [0107], [0123], [0298], [0300], [0302], [0312] TW 201533808 A KR 10-2016-0101962 A | | | |
| WO | 2021/029259 | A1 | 18 February 2021 | (Family: none) | | | |
| JP | 2012-59743 | A | 22 March 2012 | US 2012/0055015 A1 entire text, all drawings CN 102386111 A KR 10-2012-0024507 A TW 201218288 A | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014131016 A
- JP 2014229769 A
- JP 2015178635 A
- JP 2015071670 A